# EUROPÄISCHE PATENTSCHRIFT

(11) **EP 3 935 926 B1**
(45) Veröffentlichungstag und Bekanntmachung des Hinweises auf die Patenterteilung: **11.01.2023**
(21) Anmeldenummer: 20707618.3
(22) Anmeldetag: 27.02.2020
(51) Int. Cl.: H05K 7/20

(54) **DIREKTE KÜHLUNG EINES STROMRICHTERS DURCH VERWENDUNG EINER GEPRÄGTEN PLATTE**
DIRECT COOLING OF A POWER CONVERTER BY USING A STAMPED PLATE
REFROIDISSEMENT DIRECT D'UN ONDULEUR PAR UTILISATION D'UNE PLAQUE ESTAMPÉE

(30) Priorität: 04.03.2019 DE 102019202902
(43) Veröffentlichungstag der Anmeldung: 12.01.2022
(73) Patentinhaber: Audi AG, 85045 Ingolstadt (DE); Hitachi Energy Switzerland AG, 5400 Baden (CH)
(72) Erfinder: GRADINGER, Thomas, 5032 Aarau Rohr (CH); APELSMEIER, Andreas, 85131 Pollenfeld (DE); SÖHNLE, Benjamin, 85051 Ingolstadt (DE); TORRESIN, Daniele, 5400 Baden (CH)
(86) Internationale Anmeldenummer: PCT/EP2020/055139
(87) Internationale Veröffentlichungsnummer: WO 2020/178131

(56) Entgegenhaltungen:
- EP-A1- 3 276 657
- US-A1- 2016 143 193

## Beschreibung

Gegenstand der vorliegenden Erfindung ist ein Stromrichter umfassend zumindest ein Halbleitermodul mit einer Grundplatte und ein Kühlgehäuse.

Die starke Zunahme von elektrischen Fahrzeugen erzeugt einen hohen Druck auf die Leistung und die Kosten von Leistungshalbleitermodulen, die in elektrischen Antriebssträngen verwendet werden. Für Halbleitermodule bedeutet dies insbesondere eine kontinuierliche Entwicklung hin zu höheren Betriebstemperaturen und höheren Leistungsdichten.

Ein möglicher Weg, um zulässige Betriebstemperaturen auf ein höheres Niveau auszudehnen, kann ein Ersetzen des konventionellen Vergusses von Halbleitermoduloberseiten durch Spritzguss sein. Dabei kann ein spritzgussgeformtes Modul eine Grundplatte, die in einer Formmasse gehalten wird, aufweisen. Für eine optimale Kühlung können Kühlstrukturen direkt in die Grundplatte integriert ausgebildet sein, wobei die Kühlstrukturen in Kontakt mit einem Kühlfluid stehen.

Ein Halbleitermodul bzw. Halbbrückenmodul umfasst in der Regel zwei funktionale Wechsler. Um einen Dreiphasenkonverter bereitzustellen, müssen drei Halbleitermodule kombiniert werden. Demnach muss ein Kühler eine Einlassöffnung und eine Auslassöffnung aufweisen, wobei ein Kühlfluid, dass durch den Kühler geführt wird, die Kühlstrukturen aller drei Halbleitermodule durchfließen muss.

Es ist denkbar, alle sechs funktionalen Wechsler des Stromrichters auf einer einzigen, großen Platte anzuordnen. Generell besteht jedoch eine Grenze beim Formpressen hinsichtlich des maximal möglichen Volumens der Formmasse. Dieses Volumen wird bei einer Kombination von drei Halbleitermodulen überschritten. Wenn zudem alle Halbleiterchips auf einer einzigen Grundplatte verbaut werden bevor diese getestet wurden, führt dies zu einer erheblichen Verringerung der Produktionsausbeute aufgrund fehlerhafter Chips oder Verbindungen. Um einen guten Ertrag zu erzielen, ist es daher wichtig, Halbbrückenmodule einzeln herzustellen und zu prüfen, bevor sie zu einem Stromrichter kombiniert werden.

Aus dem Dokument EP 0 831 684 A2 ist eine Verpackung von Leistungselektronik bekannt. Die Verpackung hat eine tiefgezogene, hutförmige Abdeckung und eine flache versiegelte Basis, die miteinander verbunden sind, um die elektronische Leiterplatte durch Umfalten einer herabhängenden Umfangskante der Abdeckung um die Umfangskante herum zu schließen. Die Abdeckung kann eine L-förmige Umfangskante aufweisen, wobei ein erster Abschnitt radial nach außen vorsteht und ein zweiter Abschnitt nach unten hängt. Weitere Beispiele sind aus den Veröffentlichungen EP 3 276 657 A1 und US 2016/143193 A1 vorbekannt.

Es ist Aufgabe der vorliegenden Erfindung, einen Stromrichter bereitzustellen, der eine zuverlässige, kompakte und ökonomische Anordnung von verschiedenen eng kombinierten Halbbrückenmodulen, insbesondere einer Sixpack-Konfiguration, ermöglicht.

Diese Aufgabe wird durch einen Stromrichter mit den Merkmalen des Patentanspruchs 1 sowie durch ein Verfahren mit den Merkmalen des Patentanspruchs 7 gelöst. Vorteilhafte Weiterbildungen und Ausführungsformen sind Gegenstand der Beschreibung und der Beschreibung der Figuren.

Gegenstand der vorliegenden Erfindung ist ein Stromrichter umfassend zumindest ein Halbleitermodul mit einer Grundplatte und ein Kühlgehäuse. Erfindungsgemäß umfasst das Kühlgehäuse eine Aufnahmeplatte und einen Deckel, wobei die Aufnahmeplatte zumindest eine Aussparung aufweist, wobei die Aufnahmeplatte mit der Grundplatte des Halbleitermoduls um die zumindest eine Aussparung herum verbunden ist, wobei der Deckel mit der Aufnahmeplatte entlang eines Verbindungsbereichs um die zumindest eine Aussparung herum verbunden ist, wobei entweder die Aufnahmeplatte oder der Deckel als eine geprägte oder tiefgezogene Platte ausgebildet ist, wobei die Grundplatte eine Kühlstruktur aufweist, der das Kühlfluid in der Aussparung der Aufnahmeplatte ausgesetzt ist, dadurch gekennzeichnet, dass dass die Aufnahmeplatte eine Ausnehmung aufweist, wobei die Aufnahmeplatte eingerichtet und ausgebildet ist, einen Umströmungsblocker in der Ausnehmung aufzunehmen, wobei der Umströmungsblocker eingerichtet ist, ein Kühlfluid über die Kühlstruktur zu leiten; wobei der Umströmungsblocker das Kühlfluid an einer Umgehung der Kühlstrukturen der Halbleitermodule hindert oder eine solche reduziert.

Das Halbleitermodul umfasst in der Regel ein Substrat und eine Grundplatte, wobei die Grundplatte mittels einer Formmasse an dem Substrat angeordnet ist. Auf der Grundplatte ist typischerweise eine Kühlstruktur angeordnet. In der Regel ist die Grundplatte aus einem aluminiumbeschichteten Kupfer, aus Aluminium, aus einer Aluminiumlegierung oder aus AlSiC ( Aluminum Silicon Carbide bzw. Aluminiumsiliziumcarbid) ausgebildet.

Die Aufnahmeplatte ist als Rahmen ausgebildet und weist in der Regel zumindest eine Aussparung auf, die dazu eingerichtet ist, zumindest einen Teil der Grundplatte aufzunehmen. In der Regel ist die Aussparung eingerichtet, die Kühlstruktur der Grundplatte aufzunehmen. Die Aussparung ist in der Regel rechteckig ausgebildet. Optional kann die Aussparung abgerundete Ecken aufweisen. Die Grundplatte weist einen Verbindungsbereich auf, der jeweils um eine Aussparung der Grundplatte herum ausgebildet ist. Die Grundplatte wird in dem Verbindungsbereich mit der Aufnahmeplatte verschweißt. Dies bietet den Vorteil, dass Halbleitermodule auch nach dem Verschweißen prüfbar angeordnet sind. Durch das Verschweißen der Halbleitermodule, insbesondere der Grundplatte mit der Aufnahmeplatte, kann die Kühlstruktur der Halbleitermodule/Halbbrückenmodule nicht bis zur Grenze des Kühlkanals erweitert werden, da der Überlappungsbereich der Aufnahmeplatte und der Grundplatte des Halbleitermoduls für das Schweißgerät zugänglich sein muss. Optional kann daher ein Umströmungsblocker in das Kühlgehäuse eingesetzt werden.

Der Deckel ist eingerichtet, zusammen mit der Aufnahmeplatte das Kühlgehäuse bzw. einen Kühlkanal auszubilden. Dabei wird der Deckel in der Regel an die Aufnahmeplatte angeschweißt. Durch das Anschweißen des Deckels wird ein dichter Kühlkanal bzw. ein dichtes Kühlgehäuse gebildet, das eingerichtet ist, ein Kühlfluid zu führen. Der Deckel kann gebogen ausgebildet sein, wobei die Biegung zur Grundplatte hingebogen, von der Grundplatte weggebogen oder parallel zur Grundplatte ausgebildet sein kann. Eine zur Grundplatte hingebogene Ausgestaltung des Deckels bietet den Vorteil, dass anstatt eines T-Schweißens, bei dem zwei Platten, die in einem rechten Winkel zueinander angeordnet sind, miteinander verschweißt werden, eine Flanschverschweißung durchgeführt werden kann, da die abgerundeten Kanten des Deckels nicht in einem rechten Winkel auf die Grundplatte treffen. Eine Flanschverschweißung bietet den Vorteil, dass die Sensitivität mechanischer Toleranzen des Schweißvorgangs reduziert und die Robustheit und Dichtheit des geschlossenen Kühlgehäuses erhöht werden kann, da Flanschverschweißungen höheren Drücken standhalten. Ein weiterer Vorteil ist, dass die Aufnahmeplatte und der Deckel durch Tiefziehen oder durch Prägen hergestellt werden können. Das Prägen ist dabei eine spezielle Form des Tiefziehens mit nicht allzu großer Tiefe.

Die geprägte Ausführung der Aufnahmeplatte bietet zudem den Vorteil, dass die Herstellungskosten auf ein Minimum reduzierbar sind und gleichzeitig eine gute Schweißbarkeit und Dichtheit gewährleistet werden können, insbesondere im Vergleich zu Teilen aus Aluminium-Druckguss. Dadurch ist die vorliegende Erfindung besonders vorteilhaft für die Integration direkt Wasser gekühlter, formgepresster Halbleitermodule in einen Traktionswechselrichter für elektrische Fahrzeuge.

In Ausgestaltung sind die Grundplatte, die Aufnahmeplatte und der Deckel eingerichtet, das Kühlgehäuse oder einen Kühlkanal für ein Kühlfluid auszubilden. In der Regel sind die Grundplatte, die Aufnahmeplatte und der Deckel derart miteinander verbunden, dass zwischen ihnen ein Abstand ausgebildet ist, der eingerichtet ist, die Kühlstrukturen der Grundplatte aufzunehmen. Der Kühlkanal bzw. das Kühlgehäuse sind eingerichtet, von einem Kühlfluid durchströmbar zu sein. Ein Kühlfluid kann Wasser, eine Wasser-Glycol-Mischung oder ein anderes Kühlmittel sein.

Der Deckel ist eingerichtet, mit der Aufnahmeplatte verbindbar zu sein. Der Deckel wird mit der Aufnahmeplatte verbunden und bildet zusammen mit der Aufnahmeplatte ein Kühlgehäuse oder einen Kühlkanal aus. Die notwendige Höhe (Volumen) des Kühlgehäuses bzw. des Kühlkanals, insbesondere die Höhe, die notwendig ist, um eine Kühlstruktur in dem Kühlgehäuse bzw. dem Kühlkanal unterzubringen, wird durch eine Prägung oder Tiefziehen entweder der Aufnahmeplatte und/oder des Deckels oder beider erreicht.

Der Deckel weist somit optional eine Prägung oder eine Tiefziehung auf. Beispielsweise kann eine Prägung gebogen oder wannenförmig ausgebildet sein. Die Aufnahmeplatte weist somit optional eine Prägung oder eine Tiefziehung auf. Beispielsweise kann eine Prägung gebogen oder wannenförmig ausgebildet sein.

In einer Weiterbildung weist die Grundplatte eine Kühlstruktur auf, der das Kühlfluid in der Aussparung der Aufnahmeplatte ausgesetzt ist. Eine Kühlstruktur kann beispielsweise in Form von Kühlrippen oder Kühlpins ausgestaltet sein. In der Regel ist die Kühlstruktur benachbart zu einem Halbleiterchip auf der Grundplatte ausgebildet.

In einer weiteren Weiterbildung ist entweder die Aufnahmeplatte oder der Deckel wannenförmig ausgebildet, wobei die Tiefe der wannenförmigen Ausprägung die notwendige Höhe des Kühlkanals und die notwendige Höhe, um eine Kühlstruktur, insbesondere Kühlrippen, aufzunehmen, bereitstellt.

In Ausgestaltung weist der Deckel eine Einlassöffnung und eine Auslassöffnung auf, um das Halbleitermodul fluidführend zu verbinden. Durch die Einlassöffnung kann ein Kühlfluid in das Kühlgehäuse eingebracht werden. In der Regel fließt das Kühlfluid von der Einlassöffnung zu der Auslassöffnung. Dabei durchströmt das Kühlfluid zumindest eine der Kühlstrukturen der in der Platte angeordneten Halbleitermodule. Die Einlassöffnung und die Auslassöffnung können jeweils als separate Bestandteile ausgebildet sein, die in einem separaten Schritt an den Deckel anbringbar sind. Beispielsweise sind die Einlassöffnung und die Auslassöffnung an den Deckel anschweißbar. Alternativ sind die Einlassöffnung und die Auslassöffnung als Vertiefungen des Deckels ausgebildet. Die Einlassöffnung und die Auslassöffnung sind typischerweise eingerichtet, mit Steckern mit O-Ringen oder Dichtungen verbindbar zu sein.

In Ausgestaltung ist die Aufnahmeplatte mit der Grundplatte durch Schweißen verbunden, insbesondere durch Laserschweißen, und/oder der Deckel ist mit der Aufnahmeplatte durch Schweißen, insbesondere eines CMT (Cold Metal Transfer)-Schweißens, verbunden. Alternativ ist die Aufnahmeplatte mit der Grundplatte mittels Laserauftragsschweißen (LMD, Laser Metal Deposition) verbunden. In der Regel ist die Aufnahmeplatte mit der Grundplatte in dem Verbindungsbereich, der umlaufend um eine Aussparung der Aufnahmeplatte ausgebildet ist, verbunden.

In einer Weiterbildung sind die Aufnahmeplatte und die Grundplatte aus Aluminium oder einer Aluminiumlegierung ausgebildet. Alternativ ist die Aufnahmeplatte aus einem mit Aluminium beschichteten Kupfer ausgebildet.

In Ausgestaltung weist die Aufnahmeplatte eine Ausprägung auf, wobei die Aufnahmeplatte eingerichtet und ausgebildet ist, einen Umströmungsblocker in der Ausprägung aufzunehmen, wobei der Umströmungsblocker eingerichtet ist, ein Kühlfluid über die Kühlstruktur zu leiten.

Die Aufnahmeplatte kann optional den Umströmungsblocker umfassen. Der Umströmungsblocker kann auf die Aufnahmeplatte aufgebracht werden, bevor der Deckel zur Bildung des Kühlkanals mit der Aufnahmeplatte verschweißt wird. Der Umströmungsblocker ist somit als Einsatz ausgebildet und eingerichtet.

Der Umströmungsblockerblocker ist eingerichtet, das Kühlfluid zu führen. Der Umströmungsblocker ist eingerichtet, das Kühlfluid derart zu führen, dass es die Kühlstrukturen der Halbleitermodule durchströmt. Der Umströmungsblocker hindert somit das Kühlfluid an einer Umgehung der Kühlstrukturen der Halbleitermodule oder reduziert eine solche. Dies trägt zu einer verbesserten Kühlleistung bei. Zudem kann der Umströmungsblocker als Ablagefläche ausgebildet sein, auf die der Deckel auflegbar ist, nachdem der Deckel auf die Aufnahmeplatte aufgebracht wurde. Dies stellt die vertikale Ausrichtung des Deckels beim Verschweißen des Deckels mit der Aufnahmeplatte sicher. Alternativ kann der Deckel beim Vorgang des Schweißens allein auf der Kühlstruktur der Grundplatte aufliegen. Der Umströmungsblocker kann aus einem Kunststoff oder einem Metall ausgebildet sein. Das Material des Umströmungsblockers ist in Abhängigkeit eines Temperaturanstiegs eines anschließenden Prozesses wählbar. In einer weiteren alternativen Ausgestaltung ist der Umströmungsblocker in den Deckel intergiert ausgebildet.

Des Weiteren betrifft die vorliegende Erfindung ein Verfahren zur Herstellung eines Stromrichters umfassend ein Halbleitermodul mit einer Grundplatte und ein Kühlgehäuse, wobei das Kühlgehäuse eine Aufnahmeplatte und einen Deckel umfasst, nach einem der voranstehenden Merkmale.

In einem ersten Schritt wird die Aufnahmeplatte auf die Grundplatte geschweißt. Hierfür weist sowohl die Aufnahmeplatte als auch die Grundplatte in einem Verbindungsbereich ein schweißbares Material auf. Beim Verbinden der Aufnahmeplatte mit der Grundplatte ist die Grundplatte derart mit der Aufnahmeplatte verbunden, dass die Kühlstruktur durch eine Aussparung der Grundplatte hindurchgeführt wird bzw. hindurchführbar ist und so direkt dem Kühlmittel ausgesetzt wird bzw. aussetzbar ist.

In einem weiteren, in der Regel dem ersten Schritt zeitlich nachfolgenden Schritt wird der Deckel auf die Aufnahmeplatte geschweißt. Durch diesen Schritt wird das Kühlgehäuse bzw. der Kühlkanal ausgebildet. Durch das Schweißen wird ein dichtes Gehäuse ausgebildet, dass ein Kühlfluid führen kann.

Das voranstehend beschriebene Verfahren bietet des Weiteren den Vorteil, dass lediglich Material für die Aufnahmeplatte, insbesondere Aluminium benötigt wird. Zudem werden nur die Verfahren Prägung, Schneiden und Schweißen für die Herstellung benötigt. Das Material für die Aufnahmeplatte und den Deckel sowie das Material für Einlass- und Auslassöffnungen ist in der Regel Aluminium. Die Aussparungen der Aufnahmeplatte werden in der Regel ausgeschnitten oder ausgestanzt.

Um die Aufnahmeplatte mit der Grundplatte des Halbbrückenmoduls zu verbinden und die Aufnahmeplatte mit dem Deckel zu verbinden, wird in der Regel ein Schweißverfahren verwendet. Dieser Vorgang ist für ein hohes Produktionsvolumen automatisierbar.

In einer alternativen Ausführung ist das Kühlgehäuse bzw. der Kühlkanal aus einem extrudierten Material ausgebildet, wobei das Kühlgehäuse bzw. der Kühlkanal aus zumindest zwei Teilen gebildet ist.

In einer weiteren alternativen Ausführung ist das Kühlgehäuse bzw. der Kühlkanal aus druckgegossenem Aluminium.

In einer Weiterbildung des Verfahrens wird vor dem Schweißen des Deckels auf die Aufnahmeplatte ein Umströmungsblocker in die Aufnahmeplatte eingesetzt. Der Umströmungsblocker ist als ein die Halbleitermodule umlaufender Rahmen ausgestaltet.

Die Erfindung ist anhand von Ausführungsformen in der Zeichnung schematisch dargestellt und wird unter Bezugnahme auf die Zeichnung weiter beschrieben, wobei gleiche Komponenten mit gleichen Bezugsziffern gekennzeichnet sind. Es zeigt:
- Fig. 1: eine perspektivische Explosionsansicht eines Aufbaus eines erfindungsgemäßen Stromrichters,
- Fig. 2: eine Seitenansicht eines Aufbaus eines Stromrichters mit drei Ausführungsformen der Anordnung einer Grundplatte, einer Aufnahmeplatte und eines Deckels,
- Fig. 3: eine perspektivische Ansicht zweier mit einer Aufnahmeplatte verschweißten Halbleitermodule,
- Fig. 4: eine perspektivische Ansicht dreier mit einer Aufnahmeplatte verschweißten Halbleitermodule mit einem in der Aufnahmeplatte angeordneten Umströmungsblocker,
- Fig. 5: eine Seitenansicht eines Aufbaus eines erfindungsgemäßen Stromrichters mit einer Grundplatte, einer Aufnahmeplatte, einem Umströmungsblocker und einem Deckel.

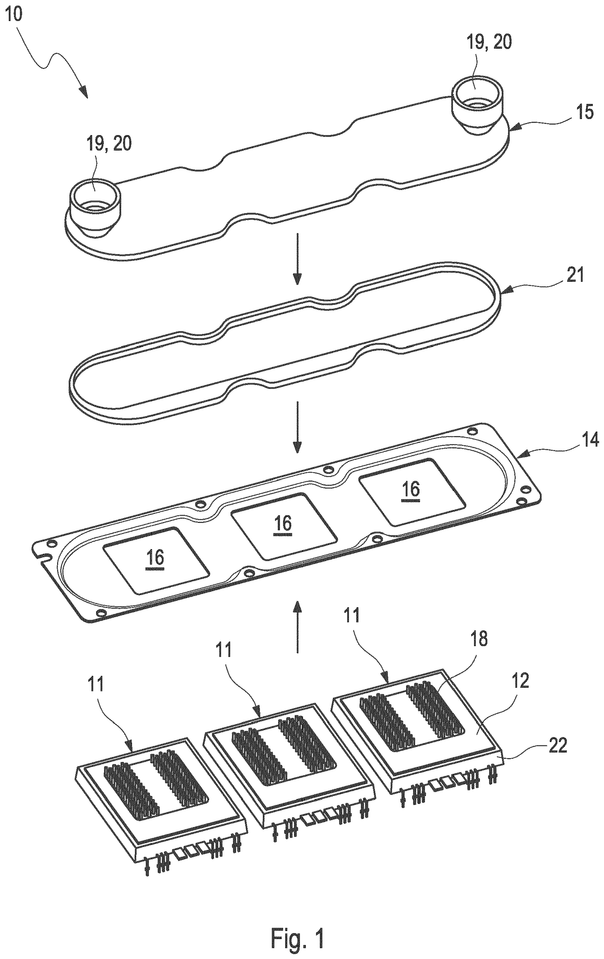

Figur 1 zeigt eine perspektivische Explosionsansicht eines Aufbaus eines erfindungsgemäßen Stromrichters 10. Gezeigt sind drei Halbleitermodule 11, die jeweils ein Substrat 22 und eine Grundplatte 12 aufweisen. Auf der Grundplatte 12 sind Kühlrippen 18 ausgebildet. Die drei Halbleitermodule 11 werden in eine gemeinsame Aufnahmeplatte 14 eingebracht, wobei die Aufnahmeplatte 14 Aussparungen 16 entsprechend der Anzahl der Halbleitermodule 11 aufweist. Eine Aussparung 16 ist jeweils eingerichtet, ein Halbleitermodul 11 derart aufzunehmen, dass die Kühlrippen 18 in der Aussparung 16 angeordnet sind.

Die drei Halbleitermodule 11 werden jeweils in einem Verbindungsbereich, der jeweils um eine Aussparung 16 ausgebildet ist, mit der Aufnahmeplatte 14 verschweißt. Die Aufnahmeplatte 14 ist eingerichtet, einen Umströmungsblocker 21 aufzunehmen. Der Umströmungsblocker 21 kann optional in der Aufnahmeplatte 14 angeordnet sein.

Der Umströmungsblocker 21 ist als ein die Halbleitermodule umlaufender Rahmen ausgestaltet. Die Aufnahmeplatte 14 weist eine Vertiefung auf, in die der Umströmungsblocker 21 eingebracht werden kann. Die Aufnahmeplatte 14 mit dem Umströmungsblocker 21 kann mittels eines Deckels 15 verschlossen werden, wodurch ein Kühlgehäuse oder Kühlkanal ausgebildet wird. Der Deckel 15 weist jeweils eine Einlass- und eine Auslassöffnung 19, 20 auf, über die ein Kühlfluid in das Kühlgehäuse bzw. den Kühlkanal eingebracht werden kann.

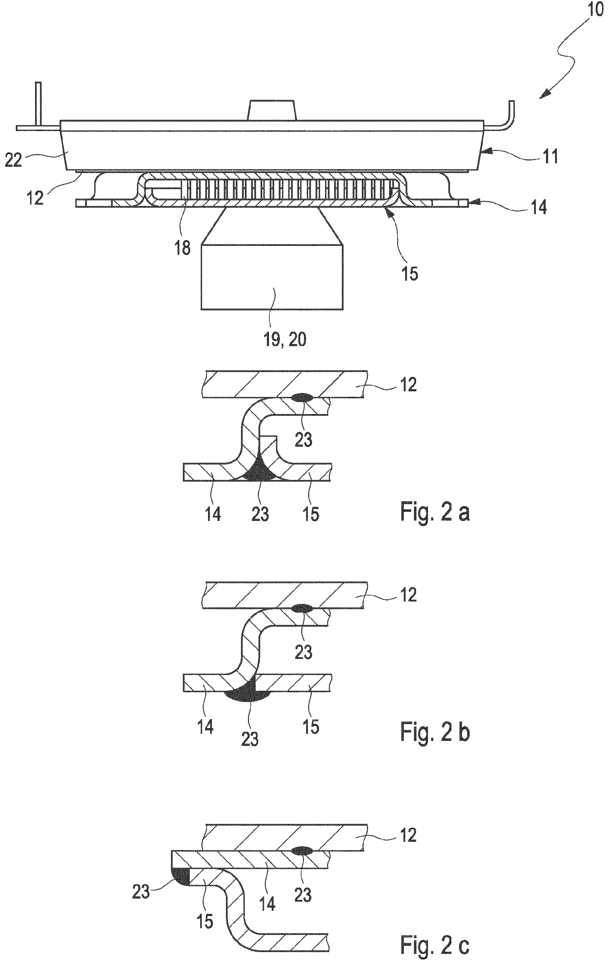

Figur 2 zeigt eine Seitenansicht eines Aufbaus eines - in Fig. 1 gezeigten - Stromrichters 10 mit drei Ausführungsformen der Anordnung einer Grundplatte 12, einer Aufnahmeplatte 14 und eines Deckels 15. In der ersten Ausführungsform Fig. 2a ist die Grundplatte 12 dargestellt sowie die Aufnahmeplatte 14 und der Deckel 15. Dabei weisen sowohl die Aufnahmeplatte 14 als auch der Deckel 15 jeweils eine geschwungene, gebogene Form auf. Die Aufnahmeplatte 14 ist über einen Verbindungsbereich 23, der als Schweißpunkt ausgebildet ist, mit der Grundplatte 12 verbunden. Der gebogene Deckel 15 ist über einen weiteren Verbindungsbereich 23, der als Schweißpunkt ausgebildet ist, mit der Aufnahmeplatte 14 verbunden.

In der zweiten Ausführungsform Fig. 2b ist die Grundplatte 12 dargestellt sowie die Aufnahmeplatte 14 und der Deckel 15. Dabei weist die Aufnahmeplatte 14 eine gebogene, geschwungene Form auf, während der Deckel 15 eben bzw. gerade ausgestaltet ist. Die Aufnahmeplatte 14 ist über einen Verbindungsbereich 23, der als Schweißpunkt ausgebildet ist, mit der Grundplatte 12 verbunden. Der lineare Deckel 15 ist über einen weiteren Verbindungsbereich 23, der als Schweißpunkt ausgebildet ist, mit der Aufnahmeplatte 14 verbunden.

In der dritten Ausführungsform Fig. 2c ist die Grundplatte 12 dargestellt sowie die Aufnahmeplatte 14 und der Deckel 15. Dabei weist die Aufnahmeplatte 14 eine gerade bzw. lineare Ausgestaltung auf, während der Deckel 15 eine gebogene, geschwungene Form aufweist. Die gerade Aufnahmeplatte 14 ist über einen Verbindungsbereich 23, der als Schweißpunkt ausgebildet ist, mit der Grundplatte 12 verbunden. Der gebogene Deckel 15 ist über einen weiteren Verbindungsbereich 23, der als Schweißpunkt ausgebildet ist, mit der Aufnahmeplatte 14 verbunden.

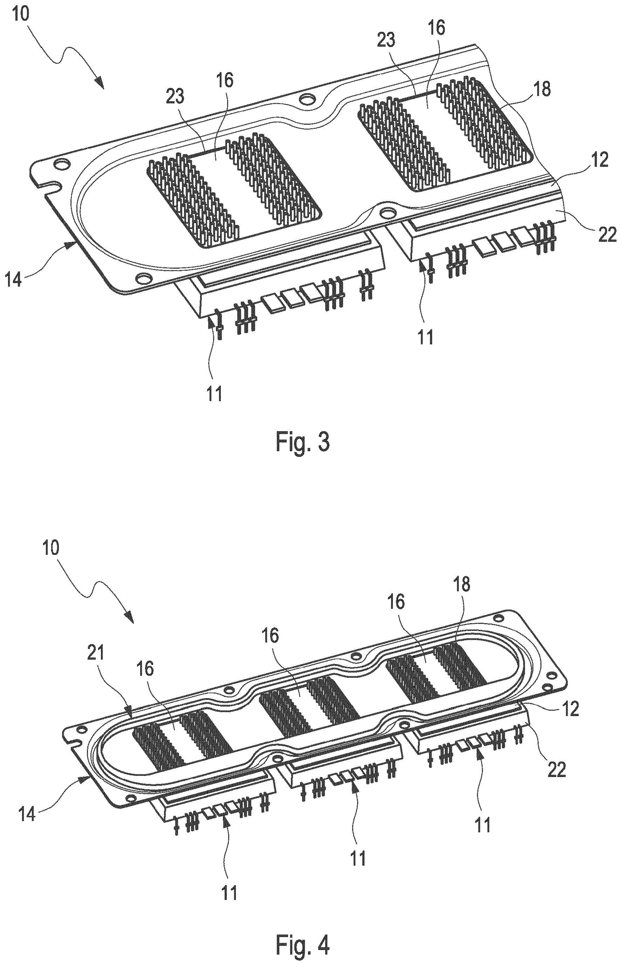

Figur 3 zeigt eine perspektivische Ansicht zweier mit einer Aufnahmeplatte 14 verschweißter Halbleitermodule 11. Die Halbleitermodule 11 weisen jeweils ein Substrat 22 und eine Grundplatte 12 auf. Auf der Grundplatte 12 sind jeweils Kühlstrukturen in Form von Kühlrippen 18 ausgebildet. Die beiden Halbleitermodule sind in jeweils eine Aussparung 16 einer Aufnahmeplatte 14 angeordnet. Die beiden Halbleitermodule 11 sind jeweils über Verbindungsbereiche 23, die jeweils um eine jeweilige Aussparung 16 herum ausgebildet sind, mit der Aufnahmeplatte 14 verbunden, insbesondere verschweißt. Die Kühlrippen 18 weisen dabei durch die Aussparungen 16 der Aufnahmeplatte 14 hindurch.

Figur 4 zeigt eine perspektivische Ansicht dreier mit einer Aufnahmeplatte 14 verschweißter Halbleitermodule 11 mit einem in der Aufnahmeplatte 14 angeordneten Umströmungsblocker 21. Die drei Halbleitermodule 11 sind jeweils mit der Aufnahmeplatte 14 verbunden, insbesondere verschweißt. Die Kühlrippen 18 weisen dabei durch die Aussparungen 16 der Aufnahmeplatte 14 hindurch. Die Aufnahmeplatte 14 weist eine Vertiefung auf, die eingerichtet ist, den Umströmungsblocker 21 aufzunehmen. Der Umströmungsblocker 21 ist als ein die drei Halbleitermodule 11 umschließender Rahmen ausgestaltet.

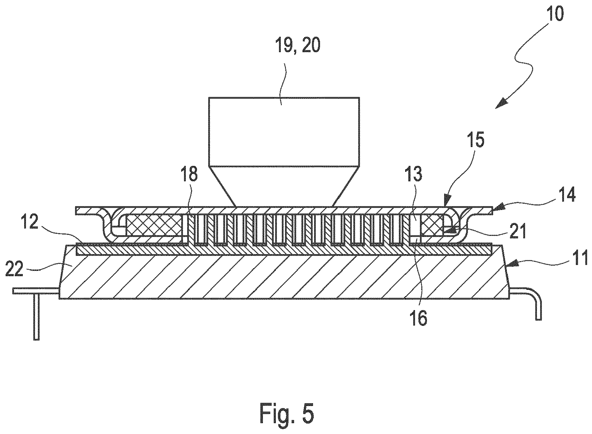

Figur 5 zeigt eine Seitenansicht eines Aufbaus eines erfindungsgemäßen Stromrichters 10 mit einer Grundplatte 12, einer Aufnahmeplatte 14, einem Umströmungsblocker 21 und einem Deckel 15. Sowohl der Deckel 15 als auch die Aufnahmeplatte 14 weisen jeweils eine Prägung auf, die jeweils als geschwungene, gebogene Form ausgebildet ist. Die Prägung der Aufnahmeplatte 14 ist entgegengesetzt zu der Prägung des Deckels 15 ausgebildet, wodurch ein Kühlgehäuse 13 bzw. ein Kühlkanal ausgebildet ist, das/der die Kühlstruktur 18 des Halbleitermoduls 11 aufnehmen kann.

Die Aufnahmeplatte 14 ist über einen Verbindungsbereich, der als Schweißpunkt ausgebildet ist, mit der Grundplatte 12 verbunden. Der gebogene Deckel 15 ist über einen Verbindungsbereich, der als Schweißpunkt ausgebildet ist, mit der Aufnahmeplatte 14 verbunden. Des Weiteren ist der Umströmungsblocker 21 in der Aufnahmeplatte 14 dargestellt.

### BEZUGSZEICHENLISTE:

- 10: Stromrichter
- 11: Halbleitermodul
- 12: Grundplatte
- 13: Kühlgehäuse
- 14: Aufnahmeplatte
- 15: Deckel
- 16: Aussparung
- 17: Kühlkanal
- 18: Kühlstruktur, Kühlrippen
- 19: Einlassöffnung
- 20: Auslassöffnung
- 21: Umströmungsblocker
- 22: Substrat
- 23: Verbindungsbereich

## Patentansprüche

1. Stromrichter (10) umfassend zumindest ein Halbleitermodul (11) mit einer Grundplatte (12), und ein Kühlgehäuse (13), wobei das Kühlgehäuse (13) eine Aufnahmeplatte (14) und einen Deckel (15) umfasst, wobei die Aufnahmeplatte (14) zumindest eine Aussparung (16) aufweist, wobei die Aufnahmeplatte (14) mit der Grundplatte (12) des Halbleitermoduls (11) um die zumindest eine Aussparung (16) herum verbunden ist, wobei der Deckel (15) mit der Aufnahmeplatte (14) entlang eines Verbindungsbereichs (23) um die zumindest eine Aussparung (16) herum verbunden ist, wobei entweder die Aufnahmeplatte (14) oder der Deckel (15) als eine geprägte oder tiefgezogene Platte ausgebildet ist, wobei die Grundplatte (12) eine Kühlstruktur (18) aufweist, der ein Kühlfluid in der Aussparung (16) der Aufnahmeplatte (14) ausgesetzt ist, **dadurch gekennzeichnet, dass** die Aufnahmeplatte (14) eine Ausnehmung aufweist, wobei die Aufnahmeplatte (14) eingerichtet und ausgebildet ist, einen Umströmungsblocker (21) in der Ausnehmung aufzunehmen, wobei der Umströmungsblocker (21) eingerichtet ist, das Kühlfluid über die Kühlstruktur (18) zu leiten, wobei der Umströmungsblocker (21) somit das Kühlfluid an einer Umgehung der Kühlstruktur des Halbleitermoduls (11) hindert oder eine solche reduziert.

2. Stromrichter (10) nach Anspruch 1, **dadurch gekennzeichnet, dass** die Grundplatte (12), die Aufnahmeplatte (14) und der Deckel (15) eingerichtet sind, das Kühlgehäuse (13) oder einen Kühlkanal (17) für das Kühlfluid auszubilden.

3. Stromrichter (10) nach einem der voranstehenden Ansprüche, **dadurch gekennzeichnet, dass** entweder die Aufnahmeplatte (14) oder der Deckel (15) wannenförmig ausgebildet sind, wobei die Tiefe der wannenförmigen Ausprägung die notwendige Höhe des Kühlkanals (17) und die notwendige Höhe, um eine Kühlstruktur (18), insbesondere Kühlrippen, aufzunehmen, bereitstellt.

4. Stromrichter (10) nach einem der voranstehenden Ansprüche, **dadurch gekennzeichnet, dass** der Deckel (15) eine Einlassöffnung (19) und eine Auslassöffnung (20) aufweist, um das Halbleitermodul (11) fließend zu verbinden.

5. Stromrichter (10) nach einem der voranstehenden Ansprüche, **dadurch gekennzeichnet, dass** die Aufnahmeplatte (14) mit der Grundplatte (12) durch Schweißen verbunden ist, insbesondere durch Laserschweißen, und/oder der Deckel (15) mit der Aufnahmeplatte (14) durch Schweißen, insbesondere einer CMT-Fügetechnik, verbunden ist.

6. Stromrichter (10) nach einem der voranstehenden Ansprüche, **dadurch gekennzeichnet, dass** die Aufnahmeplatte (14) und die Grundplatte (12) aus Aluminium oder einer Aluminiumlegierung ausgebildet sind.

7. Verfahren zur Herstellung eines Stromrichters (10) umfassend ein Halbleitermodul (11) mit einer Grundplatte (12) und ein Kühlgehäuse (13), wobei das Kühlgehäuse (13) eine Aufnahmeplatte (14) und einen Deckel (15) umfasst, nach einem der voranstehenden Ansprüche, umfassend die folgenden Schritte:
Bildung einer Ausnehmung in der Aufnahmeplatte (14);
Aufnahme eines Umströmungsblockers (21) in der Ausnehmung,
Leiten des Kühlfluids über die Kühlstruktur (18), wobei der Umströmungsblocker (21) somit das Kühlfluid an einer Umgehung der Kühlstruktur des Halbleitermoduls (11 ) hindert oder eine solche reduziert; a) Schweißen der Aufnahmeplatte (14) auf die Grundplatte (12), b) Schweißen des Deckels (15) auf die Aufnahmeplatte (14).

8. Verfahren nach Anspruch 7, wobei vor dem Schweißen des Deckels auf die Aufnahmeplatte (14) ein Umströmungsblocker (21) in die Aufnahmeplatte (14) eingesetzt wird.

## Claims

1. Power converter (10) comprising at least one semiconductor module (11) with a base plate (12) and a cooling housing (13), wherein the cooling housing (13) comprises a receiving plate (14) and a cover (15), wherein the receiving plate (14) has at least one recess (16), wherein the receiving plate (14) is connected to the base plate (12) of the semiconductor module (11) around the at least one recess (16), wherein the cover (15) is connected to the receiving plate (14) along a connecting region (23) around the at least one recess (16), wherein either the receiving plate (14) or the cover (15) is formed as a stamped or deep-drawn plate, wherein the base plate (12) has a cooling structure (18) to which a cooling fluid is exposed in the recess (16) of the receiving plate (14), **characterised in that** the receiving plate (14) has a recess, wherein the receiving plate (14) is configured and formed to receive a surrounding flow blocker (21) in the recess, wherein the surrounding flow blocker (21) is configured to conduct the cooling fluid over the cooling structure (18), wherein the surrounding flow blocker (21) thus prevents the cooling fluid from bypassing the cooling structure of the semiconductor module (11) or reduces such bypassing.

2. Power converter (10) according to claim 1, **characterised in that** the base plate (12), the receiving plate (14) and the cover (15) are configured to form the cooling housing (13) or a cooling duct (17) for the cooling fluid.

3. Power converter (10) according to any of the preceding claims, **characterised in that** either the receiving plate (14) or the cover (15) is trough-shaped, wherein the depth of the trough-shaped embossment provides the required height of the cooling duct (17) and the required height to receive a cooling structure (18), in particular cooling ribs.

4. Power converter (10) according to any of the preceding claims, **characterised in that** the cover (15) has an inlet opening (19) and an outlet opening (20) to connect the semiconductor module (11) fluidically.

5. Power converter (10) according to any of the preceding claims, **characterised in that** the receiving plate (14) is connected to the base plate (12) by welding, in particular by laser welding, and/or the cover (15) is connected to the receiving plate (14) by welding, in particular a CMT joining technique.

6. Power converter (10) according to any of the preceding claims, **characterised in that** the receiving plate (14) and the base plate (12) are formed from aluminium or an aluminium alloy.

7. Method for producing a power converter (10) comprising a semiconductor module (11) with a base plate (12) and a cooling housing (13), wherein the cooling housing (13) comprises a receiving plate (14) and a cover (15), according to any of the preceding claims, comprising the following steps:
forming a recess in the receiving plate (14);
receiving a surrounding flow blocker (21) in the recess,
conducting the cooling fluid over the cooling structure (18), wherein the surrounding flow blocker (21) thus prevents the cooling fluid from bypassing the cooling structure of the semiconductor module (11) or reduces such bypassing; a) welding the receiving plate (14) onto the base plate (12), b) welding the cover (15) onto the receiving plate (14).

8. Method according to claim 7, wherein a surrounding flow blocker (21) is inserted into the receiving plate (14) before the cover is welded onto the receiving plate (14).

## Revendications

1. Convertisseur de courant (10) comprenant au moins un module semi-conducteur (11) avec une plaque de base (12), et un compartiment de réfrigération (13), dans lequel le compartiment de réfrigération (13) comprend une plaque de montage (14) et un couvercle (15), dans lequel la plaque de montage (14) présente au moins un évidement (16), dans lequel la plaque de montage (14) est reliée à la plaque de base (12) du module semi-conducteur (11) autour de l'au moins un évidement (16), dans lequel le couvercle (15) est relié à la plaque de montage (14) le long d'une zone de liaison (23) autour de l'au moins un évidement (16), dans lequel soit la plaque de montage (14) soit le couvercle (15) est réalisé en tant que plaque gaufrée ou emboutie, dans lequel la plaque de base (12) présente une structure de réfrigération (18) à laquelle un fluide de réfrigération dans l'évidement (16) de la plaque de montage (14) est exposé, **caractérisé en ce que** la plaque de montage (14) présente un creux, dans lequel la plaque de montage (14) est conçue et réalisée pour accueillir un bloqueur d'écoulement (21) dans le creux, dans lequel le bloqueur d'écoulement (21) est conçu pour diriger le fluide de réfrigération via la structure de réfrigération (18), dans lequel le bloqueur d'écoulement (21) et donc le fluide de réfrigération empêche un contournement de la structure de réfrigération du module semi-conducteur (11) ou réduit celui-ci.

2. Convertisseur de courant (10) selon la revendication 1, **caractérisé en ce que** la plaque de base (12), la plaque de montage (14) et le couvercle (15) sont conçus pour réaliser le compartiment de réfrigération (13) ou un canal de réfrigération (17) pour le fluide de réfrigération.

3. Convertisseur de courant (10) selon l'une quelconque des revendications précédentes, **caractérisé en ce que** soit la plaque de montage (14) soit le couvercle (15) est réalisé en forme de cuvette, dans lequel la profondeur de la forme de cuvette fournit la hauteur nécessaire du canal de réfrigération (17) et la hauteur nécessaire pour accueillir une structure de réfrigération (18), en particulier des nervures de réfrigération.

4. Convertisseur de courant (10) selon l'une quelconque des revendications précédentes, **caractérisé en ce que** le couvercle (15) présente une ouverture d'entrée (19) et une ouverture de sortie (20) pour relier de manière fluide le module semi-conducteur (11).

5. Convertisseur de courant (10) selon l'une quelconque des revendications précédentes, **caractérisé en ce que** la plaque de montage (14) est reliée à la plaque de base (12) par le biais d'une soudure, en particulier par le biais d'une soudure au laser, et/ou le couvercle (15) est relié à la plaque de montage (14) par le biais d'une soudure, en particulier d'une technique d'assemblage CMT.

6. Convertisseur de courant (10) selon l'une quelconque des revendications précédentes, **caractérisé en ce que** la plaque de montage (14) et la plaque de base (12) sont réalisées en aluminium ou en alliage d'aluminium.

7. Procédé destiné à la production d'un convertisseur de courant (10) comprenant un module semi-conducteur (11) avec une plaque de base (12) et un compartiment de réfrigération (13), dans lequel le compartiment de réfrigération (13) comprend une plaque de montage (14) et un couvercle (15), selon l'une quelconque des revendications précédentes, comprenant les étapes suivantes :
formation d'un creux dans la plaque de montage (14) ;
montage d'un bloqueur d'écoulement (21) dans le creux,
conduite du fluide de réfrigération via la structure de réfrigération (18), dans lequel le bloqueur d'écoulement (21) et donc le fluide de réfrigération empêche un contournement de la structure de réfrigération du module semi-conducteur (11) ou réduit celui-ci ; a) soudure de la plaque de montage (14) sur la plaque de base (12), b) soudure du couvercle (15) sur la plaque de montage (14).

8. Procédé selon la revendication 7, dans lequel avant la soudure du couvercle sur la plaque de montage (14) un bloqueur d'écoulement (21) est utilisé dans la plaque de montage (14).
